# EUROPÄISCHE PATENTSCHRIFT

(11) **EP 4 031 884 B1**
(45) Veröffentlichungstag und Bekanntmachung des Hinweises auf die Patenterteilung: **06.11.2024**
(21) Anmeldenummer: 20775596.8
(22) Anmeldetag: 16.09.2020
(51) Int. Cl.: G01R 15/20

(54) **SENSORVORRICHTUNG MIT SENSOR UND STROMRICHTER**
SENSOR DEVICE WITH SENSOR AND CURRENT CONVERTER
DISPOSITIF DE CAPTEUR AVEC CAPTEUR ET CONVERTISSEUR DE COURANT

(30) Priorität: 20.09.2019 DE 102019214325; 15.09.2020 DE 102020211526
(43) Veröffentlichungstag der Anmeldung: 27.07.2022
(73) Patentinhaber: Robert Bosch GmbH, 70442 Stuttgart (DE)
(72) Erfinder: KIENZLE, Ralf, 70825 Korntal-Muenchingen (DE)
(86) Internationale Anmeldenummer: PCT/EP2020/075800
(87) Internationale Veröffentlichungsnummer: WO 2021/052979

(56) Entgegenhaltungen:
- FR-A1- 2 293 831
- US-A1- 2006 232 902
- US-A1- 2009 039 880
- US-A1- 2016 011 241

## Beschreibung

Die vorliegende Erfindung betrifft eine Sensorvorrichtung mit einem Sensor, einen Stromrichter mit einer solchen Sensorvorrichtung sowie eine Verwendung einer solchen Sensorvorrichtung.

### Stand der Technik

Zur Ansteuerung bzw. zum Betrieb von elektrischen Maschinen in beispielsweise Hybrid- oder Elektrofahrzeugen werden Stromrichter verwendet, die in aller Regel dazu geeignet und eingerichtet sind, die elektrische Maschine motorisch und generatorisch - je nach aktuellem Bedarf - zu betreiben. Eine Synchronmaschine beispielsweise wird mit Drehstrom betrieben, sodass zwischen einer entsprechenden Schnittstelle im Stromrichter (auch als Inverter bezeichnet) und der elektrischen Maschine drei Phasenleitungen vorgesehen sind. Zur Regelung der elektrischen Maschine müssen in aller Regel die Ströme der bzw. in den Phasenleitungen gemessen werden. Entsprechende Strommesseinrichtungen sind aus den Dokumenten US 2006/232902 A1, US 2016/011241 A1, FR 2 293 831 A1 und US 2009/039880 A1 bekannt.

Eine hierfür erforderliche Strommessung kann beispielsweise nach dem klassischen Prinzip eines Stromsensors erfolgen, bei dem ein Hallsensor in den Luftspalt eines sog. Flusskonzentrators eintaucht. Der Flusskonzentrator (der typischerweise aus ferromagnetischem Material besteht bzw. ein solches aufweist) hat dabei die Aufgabe, das Magnetfeld, das durch den Strom z.B. in einer Phasenleitung (oder natürlich auch anderweitig) erzeugt wird, zu bündeln, zu verstärken und zu homogenisieren, so dass der Hallsensor möglichst genaue Werte liefern kann.

Dabei kann der Hallsensor beispielsweise über eine Pin-Reihe (bei einem sog. SIP bzw. Single-In-Line-Package) mit einer Leiterplatte bzw. allgemein dem Schaltungsträger verbunden werden. Aufgrund immer höherer Zwischenkreisspannungen sowie schnellerer Schaltvorgängen im Stromrichter entstehen grö-ßere, bisher noch nicht beachtete und unerwünschte Störungen. Insbesondere wird zwischen Leiterabschnitten, mittels derer der Hallsensor mit der Leiterplatte verbunden ist (z.B. die beiden Versorgungspins) eine Fläche aufgespannt, welche von den magnetischen Feldlinien des zu messenden Magnetfeldes durchsetzt wird. Im Falle eines zeitlich veränderlichen magnetischen Flusses, in der Regel durch ein zeitlich veränderliches Magnetfeld, wird eine Spannung in dieser Fläche induziert. Die Größe dieser Spannung ist dabei proportional zur Größe der durchsetzten Fläche, zur Stärke des Magnetfelds und zur Frequenz des Signals.

Die typischerweise zu messenden Ströme selbst weisen meist keine sehr hohen Frequenzen auf, diese liegen z.B. bei weniger als 10 kHz. Bei jedem Schaltvorgang der Leistungselektronik im Stromrichter müssen jedoch parasitäre Kapazitäten umgeladen werden (z.B. eine Schirmkapazität von Phasenleitungen und/oder eine Kapazität der Last bzw. der elektrischen Maschine zum Gehäuse bzw. zur Masse). Der dazu nötige Strom fließt auch durch die Phasenleitungen. Das dabei entstehende Magnetfeld durchsetzt nicht nur den Hallsensor, sondern kann auch weitere Flächen zwischen den Leiterbahnen durchsetzen und bei Frequenzen von z.B. mehr als 1 MHz eine relevante Störspannung zwischen den Sensorbeinchen (Pins) induzieren.

Falls eine geringe Dämpfung vorhanden ist, entsteht ein Schwingvorgang, der eine höhere Frequenz, z.B. mehr als 1 MHz, aufweisen kann. Je größer die Kapazität und je größer die Zwischenkreisspannung sind, die beim Schaltvorgang auf die Kapazität geschaltet werden, desto größer ist die dann entstehende Stromamplitude des Schwingvorgangs. Je nach Dämpfung kann der Schwingvorgang nur wenige Perioden (z.B. weniger als fünf) oder aber relativ viele (z.B. mehr als 20) umfassen, bis er auf kleine Werte abgeklungen ist.

Diese, aufgrund des höherfrequenten Schwingvorgangs zwischen zwei Leiterabschnitten des Hallsensors induzierte Spannung wird somit auf die Versorgungsspannung des Hallsensors aufmoduliert. Der Hallsensor reagiert dadurch ggf. mit einem nicht mittelwertfreien Störsignal auf dem Ausgangspin (d.h. einem Anschluss zur Erfassung der im Hallsensor induzierten Spannung, der Hallspannung) über eine gewisse Zeit (typischerweise einige Mikrosekunden ab dem Schaltvorgang) und das einzulesende Spannungssignal, das der Höhe des zu messenden Stroms entsprechen sollte, wird bzw. ist verfälscht.

### Offenbarung der Erfindung

Erfindungsgemäß werden eine Sensorvorrichtung mit einem Sensor, ein Stromrichter sowie eine Verwendung einer Sensorvorrichtung mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung betrifft eine Sensorvorrichtung mit einem Sensor, einem Schaltungsträger, Leiterabschnitten zur Stromversorgung des Sensors und zum Erfassen eines vom Sensor erzeugten Ausgangssignals, mittels welcher der Sensor mit dem Schaltungsträger verbunden ist, und einer Versorgungs- und Ausleseeinrichtung. Die Versorgungs- und Ausleseeinrichtung, die auch auf dem Schaltungsträger angeordnet sein kann, dient dabei insbesondere zur Strom- bzw. Spannungsversorgung des Sensors sowie zur Erfassung und auch dem Auslesen und ggf. Auswerten des vom Sensor ausgegebenen Ausgangssignals, insbesondere einem Spannung- oder Stromsignal. Die Leiterabschnitte können dabei insbesondere auch etwaige Pins am Sensor bzw. einem Gehäuse des Sensors umfassen.

Eine solche Sensorvorrichtung dient zunächst primär zum Messen einer beliebigen Messgröße, beispielsweise eines Stroms. Insbesondere bei Strommessungen (sowie auch direkt bei Magnetfeldmessungen) kann jedoch die Messung durch Magnetfelder negativ beeinflusst werden, wie oben erläutert. Die Erfindung entfaltet daher bei Stromsensoren und Magnetfeldsensoren, wie z.B. Hall-Sensoren oder Sensoren, die auf AMR ("Anisotropic Magneto Resistance"), GMR ("Giant Magneto Resistance"), TMR ("Tunnel Magneto Resistance"), IMC ("Integrated Magnetic Concentrator") oder anderen magnetoresistiven Effekten beruhen, besondere Vorteile, insbesondere bei solchen, bei denen bei denen eine Stromänderung oder ggf. Magnetfeldänderung auf eine (insbesondere lineare) Spannungsänderung am Ausgang des Sensors abgebildet wird.

Bevorzugt weist die Sensorvorrichtung weiterhin einen, insbesondere ringförmigen, Flusskonzentrator, der zweckmäßigerweise aus einem ferromagnetischen Material besteht oder ein solches aufweist, mit einem Spalt auf, wobei der Sensor, bei dem es sich dann insbesondere um einen Magnetfeldsensor handelt, in dem Spalt angeordnet ist, und zwar zweckmäßigerweise derart, dass die in dem Spalt vorhandenen magnetischen Feldlinien senkrecht zu einer Sensorebene des - typischerweise flach ausgebildeten -Sensors ausgerichtet sind. Auf diese Weise kann die Sensorvorrichtung auch zum Messen eines Stroms durch beispielsweise einen Leiter verwendet werden, wie dies vorstehend in Bezug auf einen Phasenstrom bei einer elektrischen Maschine erwähnt wurde. Unabhängig davon hängt das der vorliegenden Erfindung zugrundeliegende Prinzip aber nicht davon ab, wie eine hochfrequente Störung des magnetischen Feldes, welches den Sensor durchsetzt, zustande kommt.

Bei der vorgeschlagenen Sensorvorrichtung sind nun jeweilige Kontaktstellen von zwei der Leiterabschnitte auf dem Schaltungsträger elektrisch mittels eines Kondensators (und insbesondere auch mittels entsprechender Verbindungsleitungen von den Kontaktstellen zum Kondensator) verbunden, sodass die zwei Leiterabschnitte, der Kondensator und der Sensor Bestandteile einer elektrischen Schleife sind. Dabei gehören diese Bestandteile zu einer gemeinsamen, ersten elektrischen Schleife, oder aber zu zwei verschiedenen elektrischen Schleifen, wie später noch näher erläutert. Die erste elektrische Schleife umfasst die Leiterabschnitte, die Kontaktstellen sowie den Kondensator und insbesondere auch den Sensor selbst bzw. einen Teil davon. Unter einer Kontaktstelle eines Leiterabschnitts auf dem Schaltungsträger ist hierbei insbesondere eine Position auf dem Schaltungsträger zu verstehen, an welcher der Leiterabschnitt elektrisch und/oder mechanisch mit dem Schaltungsträger - und dort dann entsprechenden weiteren Leitern - verbunden ist, z.B. Lötstellen.

Auf diese Weise, d.h. durch den Kondensator, der (direkt) die Kontaktstellen, zweckmäßigerweise unterhalb des Gehäuses, verbindet, kann besonders einfach und kostengünstig eine möglichst kleine Fläche zwischen zwei Pins des Gehäuses bzw. zwei Leiterabschnitten (elektrische Schleife), die vom Magnetfeld durchsetzt ist, erreicht werden. Dies wiederum führt dazu, dass hochfrequente Störungen im Magnetfeld einen geringeren Einfluss haben, also zu einer geringeren, auf eine an den Leiterabschnitten anliegenden (Versorgungs-)Spannung aufmodulierten Störspannung führen.

Ein Sensor wie in der erwähnten Sensorvorrichtung kann beispielsweise vier solcher Leiterabschnitte (die auch entsprechende Pins am Sensor bzw. an dessen Gehäuse umfassen) aufweisen, von denen zwei zur Stromversorgung des Sensors dienen und ein anderer (meist zusammen mit dem Masse-Leiterabschnitt der Versorgung) zur Erfassung des Ausgangssignals. Der vierte Pin bzw. Leiterabschnitt erfüllt dabei meist eine Spezialfunktion. Denkbar ist aber auch, dass nur drei oder auch mehr Leiterabschnitte vorgesehen sind, z.B. kann ein Leiterabschnitt sowohl zur Stromversorgung als auch zur Erfassung der Spannung verwendet werden, wie eben erwähnt.

Welche zwei dieser Leiterabschnitte dann Bestandteile der elektrischen Schleife sind, kann grundsätzlich je nach Bedarf gewählt werden. Denkbar und mitunter auch besonders vorteilhaft ist es auch, wenn mehrere Paare von Leiterabschnitten jeweils Bestandteil einer jeweiligen elektrische Schleife mit einem jeweiligen Kondensator sind.

Denkbar ist beispielsweise, dass die zwei Leiterabschnitte (die Bestandteile der elektrischen Schleife sind) zur Stromversorgung des Sensors dienen. Ebenso denkbar ist aber auch, dass von den zwei Leiterabschnitten einer zur Stromversorgung des Sensors und einer zum Erfassen des vom Sensor erzeugten Ausgangssignals dient.

Bevorzugt ist die erste elektrische Schleife, zumindest soweit sie auf dem Schaltungsträger ausgebildet ist, derart ausgebildet, dass sie eine geringstmögliche Fläche einschließt. Soweit dies den Teil der elektrischen Schleife auf dem Schaltungsträger betrifft, bedeutet dies insbesondere, dass eine möglichst kurze (elektrische und geometrische) Verbindung zwischen den zwei Kontaktstellen der Leiterabschnitte gewählt werden soll. Dies kann beispielsweise eine geradlinige Verbindung sein.

Zweckmäßig ist es insofern auch, dass der Kondensator auf dem Schaltungsträger geometrisch zwischen den jeweiligen Kontaktstellen angeordnet ist. Dies führt dazu, dass - insbesondere bei Beibehaltung der Gestaltung der Sensorvorrichtung außerhalb des Schaltungsträgers - die vom Magnetfeld durchsetzte Fläche möglichst gering ist, zumal durch den Kondensator eine Trennung der elektrischen Schleife von übrigen Bestandteilen erfolgt. Die erwähnte Anordnung des Kondensators bedeutet - in geometrischer Hinsicht - eine Anordnung des Kondensators direkt unterhalb des Sensors bzw. eines etwaigen Gehäuses des Sensors. Die Flächenanteile sind dann zwar noch vorhanden, aber aufgrund des Kondensators abgetrennt. Der Kondensator stützt die Spannung, so dass der Einfluss von den angeschlossenen Leitungen (nicht des Sensors) geringer wird.

Für den Fall, dass die zwei Leiterabschnitte, zwischen denen der Kondensator vorgesehen ist, zur Stromversorgung des Sensors dienen, kann dieser Kondensator zugleich als Stützkondensator dienen. Durch die erwähnte (direkte) Verbindung der Kontaktstellen sowie insbesondere der Anordnung des Kondensators unterhalb des Sensors bzw. derart, dass die Fläche der elektrischen Schleife möglichst gering ist, kann dann aber ein Einfluss hochfrequenter Störungen im Magnetfeld reduziert werden.

Erfindungsgemäß weist die Sensorvorrichtung eine zweite elektrische Schleife auf, die mit dem Kondensator elektrisch verbunden ist und die derart ausgebildet ist, dass ein Stromfluss, der von einem Magnetfeld, das die erste elektrische Schleife und die zweite elektrische Schleife zugleich durchsetzt, in der zweiten elektrischen Schleife erzeugt wird, einer von dem Magnetfeld auf das Ausgangssignal des Sensors ausgeübten Störung entgegenwirkt, diese also reduziert. Dies kann beispielsweise dadurch erreicht werden, dass in der zweiten elektrischen Schleife dem Stromfluss, insbesondere einem (hochfrequenten) Wechselanteil, der von dem Magnetfeld in der ersten elektrischen Schleife erzeugt wird, entgegenwirkt wird. Anzumerken ist jedoch, dass ein solcher Sensor grundsätzlich sehr komplex aufgebaut sein kann und sämtliche Leiterabschnitte einen Einfluss haben können, der möglicherweise auch dazu führt, dass an den Leiterabschnitten zur Stromversorgung eine Erhöhung der Spannung nötig ist, um die Störungen auf dem Ausgangssignal zu reduzieren. In diesem Sinne würde dies also ggf. bedeuten, dass in der zweiten elektrischen Schleife der Stromfluss, der von dem Magnetfeld in der ersten elektrischen Schleife erzeugt wird, verstärkt wird. Zweckmäßigerweise umfasst diese zweite elektrische Schleife einen weiteren Kondensator, um etwaige Kurzschlüsse zu vermeiden.

Ein solcher Stromfluss wird dabei - gemäß dem Induktionsgesetz und sofern von einer konstanten Geometrie der elektrische Schleife ausgegangen wird - nur von einem sich (zeitlich) ändernden Magnetfeld hervorgerufen, und weist damit insbesondere (hochfrequente) Wechselanteile auf.

Anzumerken ist hierzu, dass durch die erwähnte Anbindung der zweiten elektrischen Schleife an den Kondensator und damit auch an die erste elektrische Schleife sich beide Stromflüsse bzw. die durch magnetische Felder hervorgerufenen Ladungsverschiebungen insbesondere an Knoten zwischen den beiden Schleifen überlagern. Das Ergebnis kann z.B. durch einen Phasenversatz des in der zweiten elektrischen Schleife erzeugten Stromflusses zu dem in der ersten elektrischen Schleife erzeugten Stromfluss beeinflusst werden. Hierzu können insbesondere Impedanzen (z.B. Induktivitäten) in der zweiten elektrischen Schleife vorgesehen sein, die derart gewählt sind, dass die Störungen des Ausgangssignals des Sensors kleiner werden.

Zweckmäßig kann es auch sein, wenn die zweite elektrische Schleife derart mit dem Kondensator elektrisch verbunden ist, dass eine Richtung des Stromflusses in den Kondensator aus der weiteren elektrischen Schleife gegenüber der Richtung des Stromflusses in den Kondensator aus der ersten elektrischen Schleife um einen Wert zwischen 0° und 360°, beispielsweise um 180°, phasenversetzt ist. Zudem können, falls nötig, auch hier Impedanzen oder andere passive Bauelemente oder Komponenten vorgesehen sein. Allgemein kann die zweite elektrische Schleife mit etwaigen Bauteilen derart an die (erste) elektrische Schleife angepasst werden, dass eine möglichst weitgehende Reduzierung der unerwünschten Störung in der Hallspannung erfolgt.

Da durch eine zweite Schleife die Störungen sehr gut reduziert werden können, ist es auch bevorzugt, wenn eine erste elektrische Schleife die zwei Leiterabschnitte und den Sensor, aber nicht den Kondensator, umfasst, und eine zweite elektrische Schleife die Verbindungsleitungen von den Kontaktstellen zum Kondensator und optional auch den Kondensator. Auch hier ist dann die zweite elektrische Schleife derart ausgebildet, dass ein Stromfluss, der von einem Magnetfeld, das die erste elektrische Schleife und die zweite elektrische Schleife zugleich durchsetzt, in der zweiten elektrischen Schleife erzeugt wird, einer von dem Magnetfeld auf das Ausgangssignal des Sensors ausgeübten Störung entgegenwirkt. Die elektrischen Leitungen können sich dann z.B. an einer oder mehreren Stellen kreuzen, sodass ein Übergang von der ersten zur zweiten elektrischen Schleife entsteht.

In diesem Fall kann die zweite elektrische Schleife den (dann ggf. einzigen) Kondensator umfassen, der dann - je nach Situation - als Stützkondensator dienen kann, wie zuvor schon beschrieben. Denkbar ist aber auch, dass der Kondensator zwar die zweite elektrische Schleife elektrisch schließt, aber außerhalb der Schleifenfläche liegt, also weder Bestandteil der ersten noch der zweiten elektrischen Schleife ist, wie insbesondere anhand der noch folgenden Ausführungsbeispiele in den Figuren deutlich wird. Grundsätzlich gelten die Ausführungen zur vorstehenden Variante mit der zweiten elektrischen Schleife, dass damit eine Spannung erzeugt werden kann, die der in der ersten elektrischen Schleife entstehenden Spannung entgegenwirkt und so die Störungen reduziert, hier gleichermaßen.

Zweckmäßig kann es sein, wenn noch eine dritte elektrische Schleife vorgesehen ist, die ebenfalls derart ausgebildet ist, dass ein Stromfluss, der von einem Magnetfeld, das die erste, zweite und dritte elektrische zugleich durchsetzt, in der zweiten und dritten elektrischen Schleife erzeugt wird, einer von dem Magnetfeld auf das Ausgangssignal des Sensors ausgeübten Störung entgegenwirkt. Gegenstand der Erfindung ist weiterhin ein Stromrichter für eine elektrische Maschine, der wenigstens eine erfindungsgemäße Sensorvorrichtung aufweist, der zum Erfassen eines Phasenstroms eingerichtet ist.

Gegenstand der Erfindung ist außerdem eine Verwendung einer erfindungsgemäßen Sensorvorrichtung zum Erfassen eines Phasenstroms beim Betrieb einer elektrischen Maschine mittels eines Stromrichters.

Weitere Vorteile und Ausgestaltungen der Erfindung ergeben sich aus der Beschreibung und der beiliegenden Zeichnung.

Die Erfindung ist anhand von Ausführungsbeispielen in der Zeichnung schematisch dargestellt und wird im Folgenden unter Bezugnahme auf die Zeichnung beschrieben.

### Kurze Beschreibung der Zeichnungen

- Figur 1: zeigt schematisch einen Stromrichter, bei dem eine erfindungsgemäße Sensorvorrichtung verwendet werden kann.
- Figur 2: zeigt schematisch eine erfindungsgemäße Sensorvorrichtung in einer bevorzugten Ausführungsform.
- Figur 3: zeigt schematisch eine erfindungsgemäße Sensorvorrichtung in einer weiteren bevorzugten Ausführungsform.
- Figur 4: zeigt schematisch eine erfindungsgemäße Sensorvorrichtung in einer weiteren bevorzugten Ausführungsform.
- Figur 5: zeigt schematisch eine erfindungsgemäße Sensorvorrichtung in einer weiteren bevorzugten Ausführungsform.
- Figuren 6 bis 11: zeigen schematisch erfindungsgemäße Sensorvorrichtungen in verschiedenen weiteren bevorzugten Ausführungsformen.

### Ausführungsform(en) der Erfindung

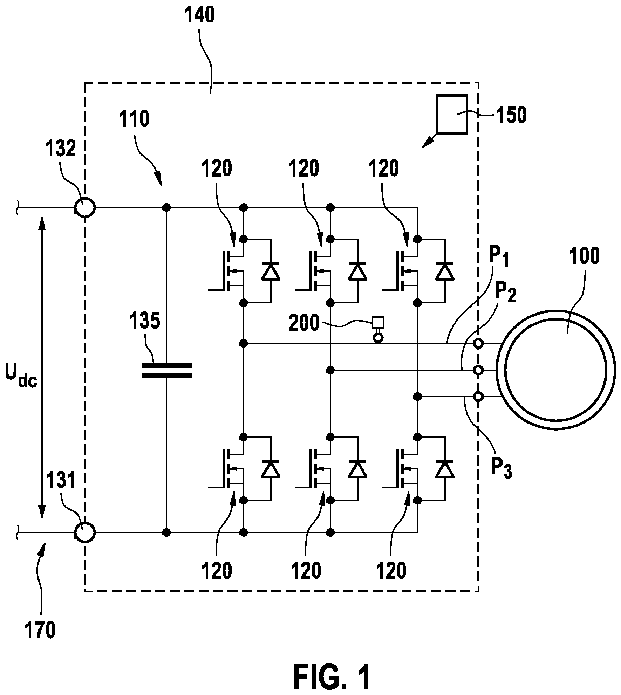

In Figur 1 ist schematisch ein beispielhaft als Brückenwechselrichter ausgebildeter Stromrichter 110 dargestellt, bei dem eine erfindungsgemäße Sensorvorrichtung verwendbar ist und der zur Ansteuerung einer elektrischen Maschine 100 dient.

Der Stromrichter 110 weist zwei Gleichspannungsanschlüsse 131, 132 auf, die auf übliche Weise, neben einem Zwischenkreiskondensator 135, mit beispielhaft sechs Halbleiterschaltern 120, beispielsweise MOSFETs, verbunden sind. Zwischen jeweils zwei der Halbleiterschalter 120 ist eine Phase der elektrischen Maschine 100 angebunden, die jeweils mit P₁, P₂ oder P₃ bezeichnet ist.

An dieser Stelle sei erwähnt, dass der Stromrichter nicht nur um als Wechselrichter, sondern insbesondere auch als Gleichrichter betrieben werden kann, sodass die elektrische Maschine insgesamt sowohl motorisch als auch generatorisch betreibbar ist.

Weiterhin ist der Stromrichter 110 mit seinen Gleichspannungsanschlüssen 131, 132 an ein Bordnetz 170, beispielsweise in einem Fahrzeug, angeschlossen. An das Bordnetz 170 wiederum sind typischerweise weitere Komponenten bzw. Verbraucher angebunden, die hier der Übersichtlichkeit halber jedoch nicht gezeigt sind.

Während eines Betriebs des Stromrichters 110 werden die einzelnen Halbleiterschalter 120 nun mittels einer Ansteuerschaltung bzw. einer Ansteuereinheit 150 auf geeignete Weise zum Öffnen bzw. Schließen angesteuert. Bei einer üblichen Ansteuerung ist beispielsweise immer je Zweig ein Schalter geschlossen und der andere geöffnet. Dabei wird eine Gleichspannung U_{dc} in eine Wechselspannung gewandelt.

Weiterhin ist beispielhaft eine bevorzugte Ausführungsform einer erfindungsgemäßen Sensorvorrichtung 200 angedeutet, mittels welcher ein Phasenstrom, also ein Strom, der in der Phase P₁ fließt, erfasst bzw. gemessen werden kann. Es versteht sich, dass weitere solcher Sensorvorrichtungen für die anderen Phasen vorgesehen sein können.

Der Stromrichter 110 und die Ansteuereinheit 150 können dabei zusammen eine Leistungselektronik 140 für die elektrische Maschine 100 bilden oder Teil einer solchen Leistungselektronik sein. Insbesondere kann auch die Sensorvorrichtung 200 Teil davon sein.

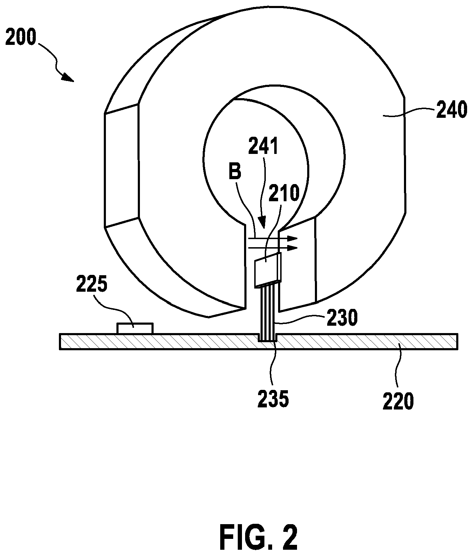

In Figur 2 ist schematisch eine erfindungsgemäße Sensorvorrichtung 200 in einer bevorzugten Ausführungsform dargestellt. Die Sensorvorrichtung 200 weist beispielhaft einen hier als Hallsensor ausgebildeten Sensor 210 auf, der mittels Leiterabschnitten, von denen einer mit 230 bezeichnet ist, auf einer Leiterplatte 220 als Schaltungsträger an einer jeweiligen Kontaktstelle, von denen eine mit 235 bezeichnet ist, elektrisch leitend angebunden und befestigt ist.

Die Leiterabschnitte werden zur Stromversorgung des Hallsensors 210 sowie zum Erfassen einer vom Hallsensor 210 erzeugten Hallspannung verwendet, wie später noch näher erläutert wird, und zwar beispielsweise mittels einer auf der Leiterplatte 220 angeordneten und entsprechend elektrisch angebundenen Versorgungs- und Ausleseeinrichtung 225.

Weiterhin weist die Sensorvorrichtung 200 einen hier ringförmigen Flusskonzentrator 240 auf, der aus einem ferromagnetischen Material wie z.B. Eisen besteht, und der einen Spalt 241 aufweist. In diesem Spalt 241, in dem sich Flusslinien eines Magnetfeldes B, das sich in dem Flusskonzentrator ausbildet, wenn beispielsweise ein Strom in einem durch die zentrale Öffnung des Flusskonzentrators 240 geführte Leitung fließt, besonders geradlinig ausbilden, ist der Hallsensor 210 angeordnet. Auf diese Weise kann ein solches Magnetfeld grundsätzlich besonders einfach und genau erfasst werden.

Außerdem ist zu erkennen, dass bei einer solchen Sensorvorrichtung mit Hallsensor und Flusskonzentrator auch die Leiterabschnitte im Magnetfeld B liegen, ebenso aber durchsetzt das Magnetfeld B auch (wenn ggf. auch in geringerem Maße) die Leiterplatte 220.

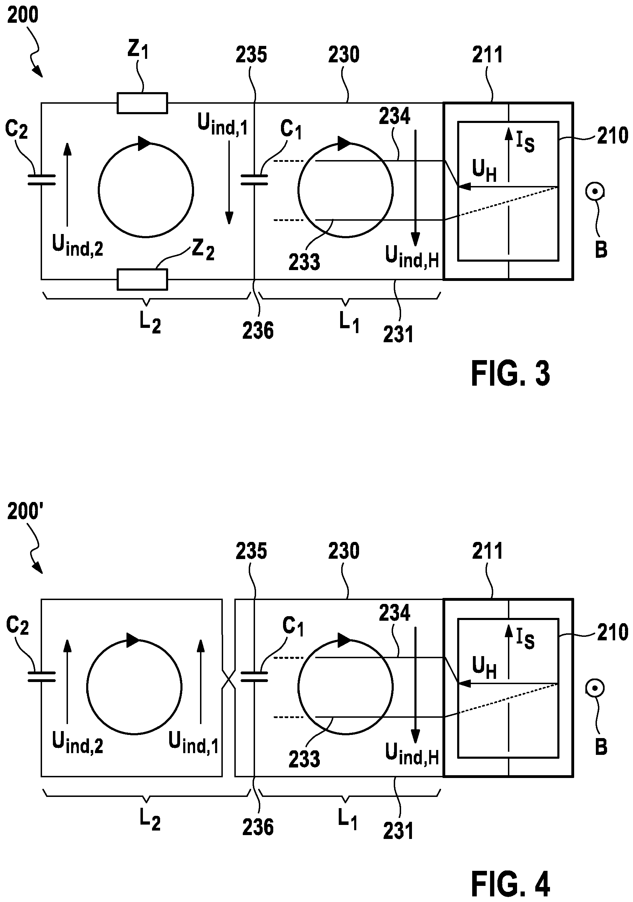

In Figur 3 ist schematisch eine erfindungsgemäße Sensorvorrichtung 200 in einer weiteren bevorzugten Ausführungsform gezeigt, und zwar als Schaltplan. Hierbei kann es sich auch um die in Figur 2 gezeigte Sensorvorrichtung handeln.

Der in einem Gehäuse 211 angeordnete Hallsensor 210 ist mittels beispielhaft vier Leiterabschnitten 230, 231, 233 und 234 mit der Leiterplatte 220 verbunden. Dabei dienen die Leiterabschnitte 230 und 231 zur Stromversorgung des Hallsensors 210, d.h. darüber (und mit den in Figur 2 gezeigten Versorgungs- und Ausleseeinrichtung) kann ein Stromfluss Is durch bzw. an den Hallsensor 210 angelegt werden.

Der Leiterabschnitt 233 oder 234 dient (zusammen mit dem mit Masse verbundenen Leiterabschnitt der Versorgung) zum Erfassen einer Hallspannung U_{H}, die in Anwesenheit eines Magnetfeldes B und des Stromes Is erzeugt wird. Es versteht sich, dass bei einer anderen Art von Sensor auch ein anderes Ausgangssignal als die Hallspannung vorhanden ist. Unabhängig von der Art des Sensors ist in der Regel dann auch noch eine Verarbeitung des Ausgangssignals vorgesehen, sodass z.B. ein digital erzeugtes, ratiometrisches Signal mit einer Mittenspannung von 2,5 V ausgegeben wird. Zum Auslesen bzw. Auswerten der Hallspannung U_{H} kann dann ebenfalls die Versorgungs- und Ausleseeinrichtung verwendet werden, die hier der Übersichtlichkeit halber nicht gezeigt ist.

Zwischen zwei Kontaktstellen 235 und 236, an denen die Leiterabschnitte 230 bzw. 231 mit der Leiterplatte (hier nicht gezeigt) verbunden sind (es handelt sich also z.B. um Einspeisepunkte der Versorgung, bezogen auf den Sensor), ist ein Kondensator C₁ geschaltet, der hier auch als Stützkondensator dient. Auf diese Weise wird eine (geschlossene) erste elektrische Schleife L₁ gebildet, die den Kondensator C₁, die Leiterabschnitte 230 und 231 sowie Teile des Hallsensors 210 umfasst.

Zudem ist eine zweite elektrische Schleife L₂ vorgesehen, die einen weiteren Kondensator C₂ sowie zwei Impedanzen Z₁ und Z₂ umfasst und mit dem Kondensator C₁ elektrisch verbunden ist. Die zweite elektrische Schleife L₂ ist dabei auf der Leiterplatte ausgebildet, beispielsweise unter Verwendung geeigneter Leiterbahnen (z.B. aus Kupfer). Hierzu sei angemerkt, dass in der gezeigten Darstellung die elektrischen Schleifen L₁ und L₂ zwar in einer Ebene liegen, in der tatsächlichen Ausführung die erste elektrische Schleife L₁ aber in etwa einen Winkel von 90° zur zweiten elektrische Schleife L₂ steht, wie sich aus Figur 2 ergibt. Hierbei kann die zweite elektrische Schleife L₂ auf der linken oder auf der rechten Seite in Bezug zu den Leiterabschnitten bzw. Kontaktstellen ausgebildet sein.

Die ausgewählte Fläche der zweiten elektrischen Schleife L₂ auf der Leiterplatte und die Fläche zwischen den beiden Leiterabschnitten 230, 231 (in diesem Beispiel diejenigen zur Stromversorgung) werden vom Magnetfeld B durchsetzt. An den Kondensatoren C₁ und C₂ fallen Induktionsspannungen U_{ind,1} und U_{ind,2} ab, ebenso an den Impedanzen. An den Versorgungsanschlüssen des Hallsensors fällt eine Induktionsspannung U_{ind,H} ab. Dies ist mittels der kreisförmigen Pfeile angedeutet.

Der Kondensator C, kann hierbei dazu verwendet werden, die Versorgungsspannung für den Hallsensor zu stützen. Zusätzlich ist die Fläche der ersten elektrischen Schleife L₁, in der bei hochfrequenten magnetischen Feldern eine parasitäre, störende Spannung induziert wird, zwischen den Leiterabschnitten möglichst klein gehalten, indem der Kondensator C, möglichst direkt unterhalb des Hallsensors auf der Leiterplatte angeordnet ist.

Damit werden auch die induzierten Störspannungen U_{ind,1} und U_{ind,H} möglichst klein gehalten. Hier ist, wie schon erwähnt, darauf zu achten, dass der Kondensator C₁ möglichst direkt unterhalb des Hallsensors 210 bzw. dessen Gehäuses 211 angebracht sein sollte (in Figur 2 auf Höhe der Kontaktstelle 235).

Der weitere Kondensator C₂ in der zweiten elektrischen Schleife L₂ wird verwendet, um einem Kurzschluss auf den Versorgungsleitungen bzw. anderen Pins oder Leiterabschnitten, die beeinflusst werden sollen, zu vermeiden. Mit den Impedanzen Z₁ und Z₂ können zusätzliche passive Bauelemente bereitgestellt werden, um eine Impedanz in der zweiten elektrischen Schleife L₂ zu erzeugen, die eine Phase und/oder Amplitude der Spannung U_{ind,1} und damit des dadurch hervorgerufenen Stromflusses günstig beeinflusst.

Amplitude, Phase und ggf. eine Frequenz (d.h. die Eigenresonanz der elektrischen Schleife) der induzierten Spannung am Kondensator C₁, also U_{ind,1}, können derart eingestellt werden, dass die fehlerhafte Reaktion des Hallsensors auf das störende (hochfrequente) Magnetfeld reduziert wird. Mit anderen Worten wird die zweite elektrische Schleife L₂ also derart ausgebildet, dass ein Stromfluss (oder eine Ladungsverschiebung), der (bzw. die) von einem Magnetfeld B, das beide elektrischen Schleifen zugleich durchsetzt, in der zweiten elektrischen Schleife L₂ erzeugt wird, einer von dem Magnetfeld (B) auf das Ausgangssignal des Sensors ausgeübten Störung entgegenwirkt.

Dabei wird aufgrund des Induktionsgesetzes eine Spannung induziert. Im ersten Moment fallen diese Spannungen nicht an den Kapazitäten ab, sondern an den Induktivitäten (jede Fläche besitzt immer eine Eigeninduktivität, unabhängig von den Bauelementen). Dann erst bauen sich Stromflüsse auf, die in den Kondensatoren Ladungsverschiebungen entstehen lassen. Dadurch verändern sich die Spannungen an den Kondensatoren (ist der Kondensator groß, ist seine Spannungsveränderung klein). Es kann also von induzierten Spannungen an den Kondensatoren gesprochen werden.

Generell muss es sich dabei nicht um die Versorgungspins bzw. Leiterabschnitte zur Stromversorgung des Hallsensors handeln, es können auch andere Signale oder Pins bzw. Leiterabschnitte mit einer Schleife, wie beschrieben, versehen werden.

In Figur 4 ist schematisch eine erfindungsgemäße Sensorvorrichtung 200' in einer weiteren bevorzugten Ausführungsform dargestellt, ebenfalls als Schaltplan.

Die Sensorvorrichtung 200' entspricht in weiten Teilen der Sensorvorrichtung 200, sodass auf die dortigen Ausführungen verwiesen werden kann.

Im Gegensatz zur Ausführungsform gemäß Figur 3 ist die zweite elektrische Schleife L₂ hier gekreuzt mit dem Kondensator C, elektrisch verbunden, so dass die Phasenlage der Spannung U_{ind,1} um 180° gedreht ist. Auch hier könnten Impedanzen wie in Figur 3 vorgesehen werden, falls nötig oder gewünscht. Die induzierte Umlaufspannung in der Fläche der zweiten Schleife L₂ wirkt sich auf die Bauelemente um 180° verdreht oder verschoben aus. Dies bedeutet, dass eine etwaige vorige Verstärkung einer Ausgangsstörung jetzt zu einer Abschwächung führen kann, und zwar aufgrund der 180°-Verschiebung. An dieser Stelle sei jedoch erwähnt, dass der Wert von 180° hier rein beispielhaft und zur Erläuterung verwendet wird.

Abhängig vom internen Verhalten und Aufbau der in der Regel komplexen Sensorvorrichtung bzw. eines entsprechenden Sensorchips können verschiedene Varianten einer elektrischen Schleife, wie sie vorstehend an Beispielen erläutert wurde, zur Verbesserung des Messsignals eingesetzt werden.

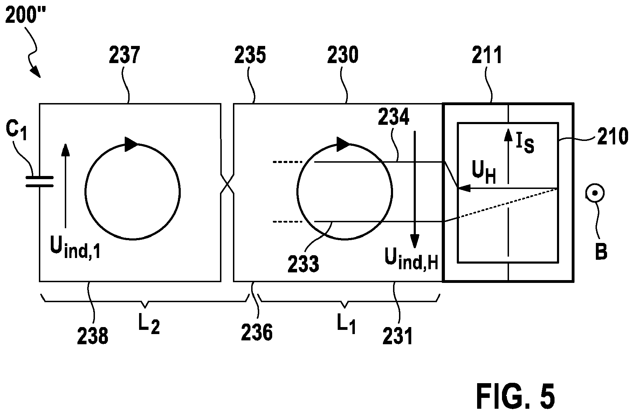

In Figur 5 ist schematisch eine erfindungsgemäße Sensorvorrichtung 200" in einer weiteren bevorzugten Ausführungsform dargestellt, ebenfalls als Schaltplan. Die Sensorvorrichtung 200" entspricht in weiten Teilen der Sensorvorrichtung 200', sodass auf die dortigen Ausführungen verwiesen werden kann.

Im Gegensatz zur Ausführungsform gemäß Figur 4 ist die zweite elektrische Schleife L₂ hier allerdings direkt nach der ersten elektrischen Schleife angeordnet und der Kondensator C₁ ist - neben Verbindungsleitungen 237, 238 von den Kontaktstellen 235, 236 zum Kondensator C, - Bestandteil der zweiten elektrischen Schleife, wobei auch hier die Phasenlage der Spannung U_{ind,1} gegenüber der Spannung U_{ind,H} verschoben ist. Auch hier könnten Impedanzen wie in Figur 3 vorgesehen werden, falls nötig oder gewünscht.

Mit anderen Worten fehlt in der Ausführungsform gemäß Figur 5 der in Figur 4 gezeigt Kondensator C, und stattdessen übernimmt der dortige Kondensator C₂ dessen Funktion. Daher sollte die Fläche der ersten elektrischen Schleife L₁ (umfassend den Sensor) durch die Leiter begrenzt werden, z.B. durch enges Zusammenbringen der Leiter mit anschließendem Übergang in die zweite elektrische Schleife L₂, die die Aufgabe hat, die induzierte Spannung der ersten Fläche durch die gegenläufige Umlaufspannung zu kompensieren. Dabei muss die zweite Fläche der zweiten elektrischen Schleife nicht symmetrisch zwischen beiden Leitern aufgeteilt sein, sondern kann auch z.B. nur mit einem Leiter auf verschiedene Arten umgesetzt werden, wie später noch beispielhaft gezeigt.

Der (einzige) Kondensator C, hat dann für die Versorgungsspannung die Aufgabe des Stützkondensators und für die Ausgangsspannung (je nachdem, welche Leiterabschnitte Bestandteil der Schleife sind) die Aufgabe des Filterkondensators.

Die induzierte Umlaufspannung in der Fläche der zweiten Schleife L₂ wirkt sich auf die Bauelemente um 180° verdreht oder verschoben aus. Dies bedeutet, dass eine etwaige vorige Verstärkung einer Ausgangsstörung jetzt zu einer Abschwächung führen kann, und zwar aufgrund der 180°-Verschiebung. An dieser Stelle sei jedoch erwähnt, dass der Wert von 180° hier rein beispielhaft und zur Erläuterung verwendet wird.

Abhängig vom internen Verhalten und Aufbau der in der Regel komplexen Sensorvorrichtung bzw. eines entsprechenden Sensorchips können verschiedene Varianten einer elektrischen Schleife, wie sie vorstehend an Beispielen erläutert wurde, zur Verbesserung des Messsignals eingesetzt werden.

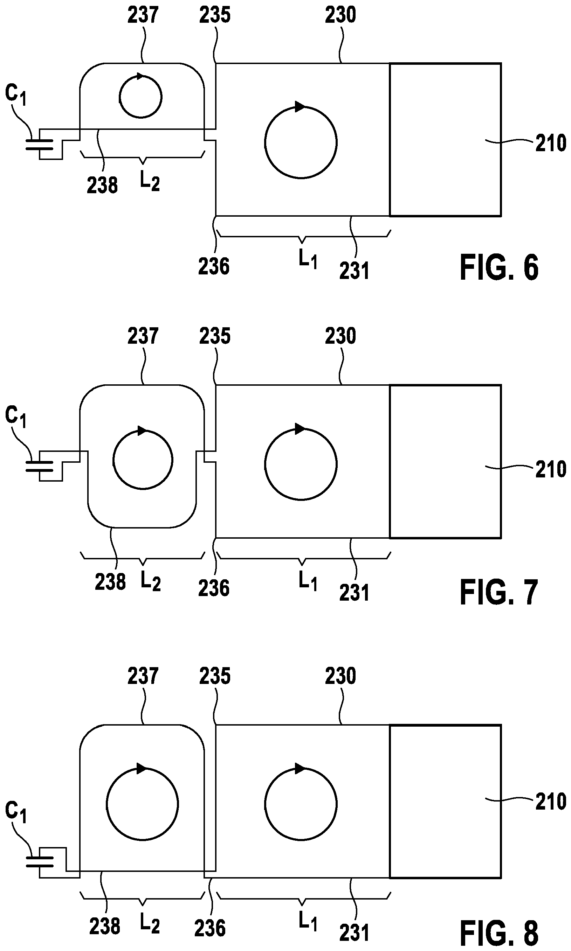

Weitere solche Beispiele sind in den Figuren 6 bis 11 schematisch gezeigt, wobei nur einige der Komponenten bezeichnet sind. Insbesondere sollen anhand der folgenden Ausführungsbeispiele Möglichkeiten der Gestaltung der zweiten elektrischen Schleife, ggf. einer dritten elektrischen Schleife, auch unter Berücksichtigung der Positionierung des Kondensators C₁, gezeigt werden. Dabei ist, wie auch in den vorstehenden Beispielen, die erste elektrische Schleife zwischen den beiden Leiterabschnitten 230, 231 gebildet. Wie erwähnt, kann diese auch zwischen anderen Leiterabschnitten gebildet sein.

Zweckmäßigerweise sollte die zweite Fläche der zweiten elektrischen Schleife L₂ immer nahe am Sensor bzw. Hallsensor 210 sein, damit das Magnetfeld für diese zweite Fläche groß genug ist. Die zweite Fläche sollte möglichst so groß wie die erste Fläche der ersten elektrischen Schleife L₁ sein. Eine positive Wirkung ist aber auch schon bei kleineren Flächen vorhanden. In Figur 6 ist hierzu ein Beispiel gezeigt, bei dem die zweite elektrische Schleife derart ausgebildet ist, dass deren (zweite) Fläche kleiner ist als die (erste) Fläche der ersten elektrischen Schleife L₁. Die zweite elektrische Schleife wird dabei maßgeblich durch die Verbindungsleitung 237 gebildet. Außerdem ist der Kondensator C, nicht Bestandteil der zweiten elektrischen Schleife L₂, was für die Funktionalität sowohl der zweiten elektrischen Schleife L₂ als auch des Kondensators C, unerheblich ist.

Bei dem Beispiel in Figur 7 ist die zweite elektrische Schleife L₂ derart ausgebildet ist, dass deren (zweite) Fläche in etwa der (ersten) Fläche der ersten elektrischen Schleife L₁ entspricht. Die zweite elektrische Schleife wird dabei maßgeblich durch die Verbindungsleitungen 237 und 238 gebildet.

Bei dem Beispiel in Figur 8 ist die zweite elektrische Schleife L₂ derart ausgebildet ist, dass deren (zweite) Fläche in etwa der (ersten) Fläche der ersten elektrischen Schleife L₁ entspricht. Die zweite elektrische Schleife wird dabei maßgeblich durch die Verbindungsleitung 237 gebildet.

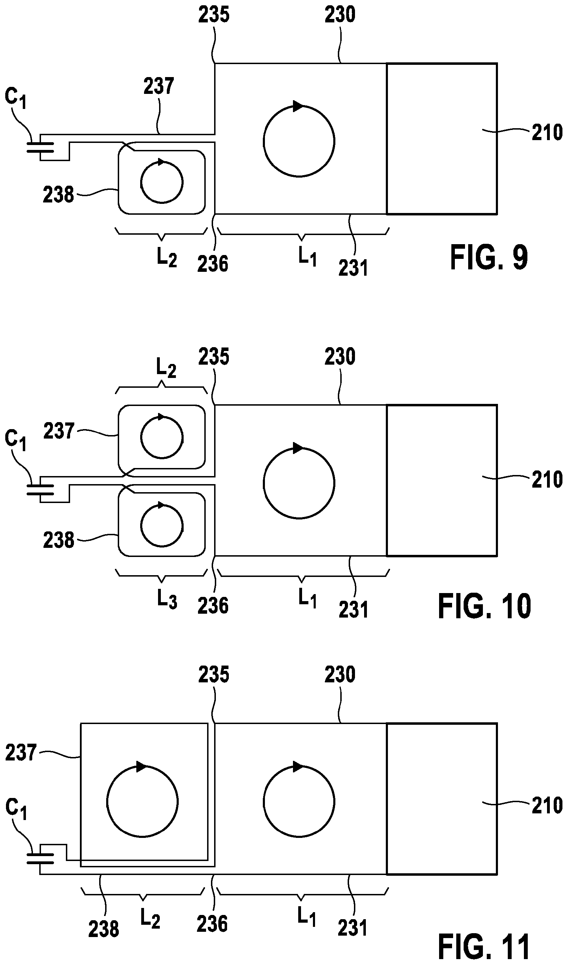

Bei dem Beispiel in Figur 9 ist die zweite elektrische Schleife L₂ derart ausgebildet ist, dass deren (zweite) Fläche kleiner ist als die (erste) Fläche der ersten elektrischen Schleife L₁. Die zweite elektrische Schleife wird dabei maßgeblich durch die Verbindungsleitung 238 gebildet. Dabei wird eine Kreuzung der Verbindungsleitung 238 vorgenommen, um die Schleife zu bilden.

Bei dem Beispiel in Figur 10 ist neben der zweiten auch eine dritte elektrische Schleife L₃ vorgesehen, wobei zweite und die dritte elektrische Schleife jeweils derart ausgebildet sind, dass deren (zweite bzw. dritte) Fläche jeweils in etwa der Hälfte der (ersten) Fläche der ersten elektrischen Schleife L₁ entspricht. Die zweite elektrische Schleife wird dabei maßgeblich durch die Verbindungsleitung 237 gebildet, die dritte elektrische Schleife durch die Verbindungsleitung 238. Wie beim Beispiel in Figur 9 wird eine Kreuzung einer jeden der Verbindungsleitungen 237, 238 vorgenommen, um die jeweilige Schleife zu bilden.

Bei dem Beispiel in Figur 11 ist die zweite elektrische Schleife L₂ derart ausgebildet, dass deren (zweite) Fläche in etwa der (erste) Fläche der ersten elektrischen Schleife L₁ entspricht. Die zweite elektrische Schleife wird dabei maßgeblich durch die Verbindungsleitung 237 gebildet. Dabei wird eine Kreuzung der Verbindungsleitung 237 vorgenommen, um die Schleife zu bilden.

## Patentansprüche

1. Sensorvorrichtung (200, 200') mit einem Sensor (210), einem Schaltungsträger (220), Leiterabschnitten (230, 231, 233, 234) zur Stromversorgung des Sensors (210) und zum Erfassen eines vom Sensor (210) erzeugten Ausgangssignals (U_{H}), mittels welcher der Sensor (210) mit dem Schaltungsträger (220) verbunden ist, und einer Versorgungs- und Ausleseeinrichtung (225),
wobei jeweilige Kontaktstellen (235, 236) von zwei der Leiterabschnitte (230, 231) auf dem Schaltungsträger (220) elektrisch mittels eines Kondensators (Ci) verbunden sind, sodass die zwei Leiterabschnitte (230, 231), der Kondensator (C₁) und der Sensor (210) Bestandteile einer elektrischen Schleife (L₁) sind,
wobei die zwei Leiterabschnitte (230, 231), der Kondensator (C₁) und der Sensor (210) Bestandteile einer ersten elektrischen Schleife (L₁) sind,
**dadurch gekennzeichnet, dass**.
die Sensorvorrichtung (200, 200') eine zweite elektrische Schleife (L₂) umfasst, die mit dem Kondensator (C₁) elektrisch verbunden und derart ausgebildet ist, dass ein Stromfluss, der von einem Magnetfeld (B), das die erste elektrische Schleife (L₁) und die zweite elektrische Schleife (L₂) zugleich durchsetzt, in der zweiten elektrischen Schleife (L₂) erzeugt wird, einer von dem Magnetfeld (B) auf das Ausgangssignal des Sensors ausgeübten Störung entgegenwirkt.

2. Sensorvorrichtung (200, 200') nach Anspruch 1, wobei die zweite elektrische Schleife (L₂) einen weiteren Kondensator (C₂) umfasst.

3. Sensorvorrichtung (200) nach Anspruch 1 oder 2, wobei die zweite elektrische Schleife (L₂) wenigstens eine Impedanz (Z₁, Z₂) umfasst.

4. Sensorvorrichtung (200') nach einem der Ansprüche 1 bis 3, wobei die zweite elektrische Schleife (L₂) derart mit dem Kondensator (C₁) elektrisch verbunden ist, dass eine Richtung des Stromflusses in den Kondensator (C₁) aus der zweiten elektrischen Schleife (L₂) gegenüber einer Richtung des Stromflusses in den Kondensator (C₁) aus der ersten elektrischen Schleife (L₁) um einen Wert zwischen 0° und 360° phasenversetzt ist.

5. Sensorvorrichtung (200, 200') mit einem Sensor (210), einem Schaltungsträger (220), Leiterabschnitten (230, 231, 233, 234) zur Stromversorgung des Sensors (210) und zum Erfassen eines vom Sensor (210) erzeugten Ausgangssignals (UH), mittels welcher der Sensor (210) mit dem Schaltungsträger (220) verbunden ist, und einer Versorgungs- und Ausleseeinrichtung (225),
wobei jeweilige Kontaktstellen (235, 236) von zwei der Leiterabschnitte (230, 231) auf dem Schaltungsträger (220) elektrisch mittels eines Kondensators (C1) verbunden sind, sodass die zwei Leiterabschnitte (230, 231), der Kondensator (C1) und der Sensor (210) Bestandteile einer elektrischen Schleife (L1) sind,
wobei die Sensorvorrichtung (200, 200") eine erste elektrische Schleife (L₁) umfasst, die die zwei Leiterabschnitte (230, 231) und den Sensor (210) umfasst, **dadurch gekennzeichnet, dass** die Sensorvorrichtung (200, 200") eine zweite elektrische Schleife (L₂) umfasst, die Verbindungsleitungen von den Kontaktstellen zum Kondensator (C₁) umfasst, wobei die zweite elektrische Schleife (L₂) derart ausgebildet ist, dass ein Stromfluss, der von einem Magnetfeld (B), das die erste elektrische Schleife (L₁) und die zweite elektrische Schleife (L₂) zugleich durchsetzt, in der zweiten elektrischen Schleife (L₂) erzeugt wird, einer von dem Magnetfeld (B) auf das Ausgangssignal des Sensors ausgeübten Störung entgegenwirkt.

6. Sensorvorrichtung (200) nach Anspruch 5, wobei die zweite elektrische Schleife (L₂) den Kondensator (C₁) umfasst.

7. Sensorvorrichtung (200) nach Anspruch 5 oder 6, weiterhin mit einer dritten elektrischen Schleife (L3), die derart ausgebildet ist, dass ein Stromfluss, der von einem Magnetfeld (B), das die erste (L₁), zweite (L₂) und dritte elektrische Schleife (L₃) zugleich durchsetzt, in der zweiten und dritten elektrischen Schleife (L₂) erzeugt wird, einer von dem Magnetfeld (B) auf das Ausgangssignal des Sensors ausgeübten Störung entgegenwirkt.

8. Sensorvorrichtung (200, 200') nach einem der Ansprüche 1 bis 7 wobei die erste elektrische Schleife (L₁), zumindest soweit sie auf dem Schaltungsträger (220) ausgebildet ist, derart ausgebildet ist, dass sie eine geringstmögliche Fläche einschließt.

9. Sensorvorrichtung (200, 200') nach einem der vorstehenden Ansprüche, wobei die zwei Leiterabschnitte (230, 231) zur Stromversorgung des Sensors (210) dienen.

10. Sensorvorrichtung nach einem der vorstehenden Ansprüche, wobei von den zwei Leiterabschnitten einer zur Stromversorgung des Sensors (210) und einer zum Erfassen des vom Sensor (210) erzeugten Ausgangssignals dient.

11. Sensorvorrichtung (200, 200') nach einem der vorstehenden Ansprüche, weiterhin mit einem Flusskonzentrator (240), insbesondere aus einem ferromagnetischen Material, mit einem Spalt (241), wobei der Sensor (210) in dem Spalt (241) angeordnet ist.

12. Sensorvorrichtung (200, 200') nach einem der vorstehenden Ansprüche, wobei der Sensor (210) als Magnetfeldsensor, insbesondere Hallsensor, ausgebildet ist.

13. Stromrichter (140) für eine elektrische Maschine (100), mit wenigstens einer Sensorvorrichtung (200, 200') nach einem der vorstehenden Ansprüche, der zum Erfassen eines Phasenstroms eingerichtet ist.

14. Verwendung einer Sensorvorrichtung (200, 200') nach einem der Ansprüche 1 bis 12 zum Erfassen eines Phasenstroms beim Betrieb einer elektrischen Maschine (100) mittels eines Stromrichters (140).

## Claims

1. Sensor device (200, 200') having a sensor (210), a circuit carrier (220), conductor sections (230, 231, 233, 234) for supplying current to the sensor (210) and for capturing an output signal (U_{H}) generated by the sensor (210), which conductor sections are used to connect the sensor (210) to the circuit carrier (220), and a supply and read-out apparatus (225),
wherein respective contact points (235, 236) of two of the conductor sections (230, 231) on the circuit carrier (220) are electrically connected by means of a capacitor (C₁), with the result that the two conductor sections (230, 231), the capacitor (C₁) and the sensor (210) are constituent parts of an electrical loop (L1),
wherein the two conductor sections (230, 231), the capacitor (C₁) and the sensor (210) are constituent parts of a first electrical loop (L₁),
**characterized in that**
the sensor device (200, 200') comprises a second electrical loop (L₂) which is electrically connected to the capacitor (C₁) and is designed in such a manner that a current flow, which is generated in the second electrical loop (L₂) by a magnetic field (B) that permeates the first electrical loop (L₁) and the second electrical loop (L₂) at the same time, counteracts interference exerted on the output signal from the sensor by the magnetic field (B).

2. Sensor device (200, 200') according to Claim 1, wherein the second electrical loop (L₂) comprises a further capacitor (C₂).

3. Sensor device (200) according to Claim 1 or 2, wherein the second electrical loop (L₂) comprises at least one impedance (Z₁, Z₂).

4. Sensor device (200') according to one of Claims 1 to 3, wherein the second electrical loop (L₂) is electrically connected to the capacitor (C₁) in such a manner that a direction of the current flow into the capacitor (C₁) from the second electrical loop (L₂) has a phase offset of a value between 0° and 360° with respect to a direction of the current flow into the capacitor (C₁) from the first electrical loop (L₁).

5. Sensor device (200, 200') having a sensor (210), a circuit carrier (220), conductor sections (230, 231, 233, 234) for supplying current to the sensor (210) and for capturing an output signal (UH) generated by the sensor (210), which conductor sections are used to connect the sensor (210) to the circuit carrier (220), and a supply and read-out apparatus (225),
wherein respective contact points (235, 236) of two of the conductor sections (230, 231) on the circuit carrier (220) are electrically connected by means of a capacitor (C1), with the result that the two conductor sections (230, 231), the capacitor (C1) and the sensor (210) are constituent parts of an electrical loop (L1),
wherein the sensor device (200, 200") comprises a first electrical loop (L₁) which comprises the two conductor sections (230, 231) and the sensor (210), **characterized in that** the sensor device (200, 200") comprises a second electrical loop (L₂) which comprises connection lines from the contact points to the capacitor (C₁), wherein the second electrical loop (L₂) is designed in such a manner that a current flow, which is generated in the second electrical loop (L₂) by a magnetic field (B) that permeates the first electrical loop (L₁) and the second electrical loop (L₂) at the same time, counteracts interference exerted on the output signal from the sensor by the magnetic field (B).

6. Sensor device (200) according to Claim 5, wherein the second electrical loop (L₂) comprises the capacitor (C₁).

7. Sensor device (200) according to Claim 5 or 6, also having a third electrical loop (L3) which is designed in such a manner that a current flow, which is generated in the second and third electrical loops (L₂) by a magnetic field (B) that permeates the first (L₁), second (L₂) and third electrical loops (L₃) at the same time, counteracts interference exerted on the output signal from the sensor by the magnetic field (B).

8. Sensor device (200, 200') according to one of Claims 1 to 7, wherein the first electrical loop (L₁), at least insofar as it is formed on the circuit carrier (220), is designed in such a manner that it encloses an area which is as small as possible.

9. Sensor device (200, 200') according to one of the preceding claims, wherein the two conductor sections (230, 231) are used to supply current to the sensor (210).

10. Sensor device according to one of the preceding claims, wherein, of the two conductor sections, one is used to supply current to the sensor (210) and one is used to capture the output signal generated by the sensor (210).

11. Sensor device (200, 200') according to one of the preceding claims, also having a flux concentrator (240), in particular made of a ferromagnetic material, having a gap (241), wherein the sensor (210) is arranged in the gap (241).

12. Sensor device (200, 200') according to one of the preceding claims, wherein the sensor (210) is in the form of a magnetic field sensor, in particular a Hall sensor.

13. Current converter (140) for an electrical machine (100), having at least one sensor device (200, 200') according to one of the preceding claims, which current converter is configured to capture a phase current.

14. Use of a sensor device (200, 200') according to one of Claims 1 to 12 for capturing a phase current when operating an electrical machine (100) by means of a current converter (140).

## Revendications

1. Arrangement capteur (200, 200') comprenant un capteur (210), un support de circuit (220), des portions de conducteur (230, 231, 233, 234) destinées à l'alimentation électrique du capteur (210) et à la détection d'un signal de sortie (U_{H}) généré par le capteur (210), au moyen desquelles le capteur (210) est relié au support de circuit (220), et un dispositif d'alimentation et de lecture (225),
des points de contact (235, 236) respectifs de deux des portions de conducteur (230, 231) sur le support de circuit (220) étant reliés électriquement au moyen d'un condensateur (C₁), de sorte que les deux portions de conducteur (230, 231), le condensateur (C₁) et le capteur (210) soient des composants d'une boucle électrique (L₁),
les deux portions de conducteur (230, 231), le condensateur (C₁) et le capteur (210) étant des composants d'une première boucle électrique (L₁),
**caractérisé en ce que**
l'arrangement capteur (200, 200') comprend une deuxième boucle électrique (L₂), qui est reliée électriquement au condensateur (C₁) et configurée de telle sorte qu'un flux de courant, qui est généré dans la deuxième boucle électrique (L₂) par un champ magnétique (B) et qui traverse à la fois la première boucle électrique (L₁) et la deuxième boucle électrique (L₂), s'oppose à une perturbation exercée par le champ magnétique (B) sur le signal de sortie du capteur.

2. Arrangement capteur (200, 200') selon la revendication 1, la deuxième boucle électrique (L₂) comprenant un condensateur supplémentaire (C₂).

3. Arrangement capteur (200) selon la revendication 1 ou 2, la deuxième boucle électrique (L₂) comprenant au moins une impédance (Z₁, Z₂).

4. Arrangement capteur (200') selon l'une des revendications 1 à 3, la deuxième boucle électrique (L₂) étant reliée électriquement au condensateur (C₁) de telle sorte qu'une direction du flux de courant dans le condensateur (C₁) provenant de la deuxième boucle électrique (L₂) est déphasée d'une valeur comprise entre 0° et 360° par rapport à une direction du flux de courant dans le condensateur (C₁) provenant de la première boucle électrique (L₁).

5. Arrangement capteur (200, 200') comprenant un capteur (210), un support de circuit (220), des portions de conducteur (230, 231, 233, 234) destinées à l'alimentation électrique du capteur (210) et à la détection d'un signal de sortie (UH) généré par le capteur (210), au moyen desquelles le capteur (210) est relié au support de circuit (220), et un dispositif d'alimentation et de lecture (225),
des points de contact (235, 236) respectifs de deux des portions de conducteur (230, 231) sur le support de circuit (220) étant reliés électriquement au moyen d'un condensateur (C1), de sorte que les deux portions de conducteur (230, 231), le condensateur (C1) et le capteur (210) soient des composants d'une boucle électrique (L1),
l'arrangement capteur (200, 200") comprenant une première boucle électrique (L₁), laquelle comprend les deux portions de conducteur (230, 231) et le capteur (210), **caractérisé en ce que** l'arrangement capteur (200, 200") comprend une deuxième boucle électrique (L₂), laquelle comprend des lignes de connexion des points de contact au condensateur (C₁), la deuxième boucle électrique (L₂) étant configurée de telle sorte qu'un flux de courant, qui est généré dans la deuxième boucle électrique (L₂) par un champ magnétique (B) et traverse à la fois la première boucle électrique (L₁) et la deuxième boucle électrique (L₂), s'oppose à une perturbation exercée par le champ magnétique (B) sur le signal de sortie du capteur.

6. Arrangement capteur (200) selon la revendication 5, la deuxième boucle électrique (L₂) comprenant le condensateur (C₁).

7. Arrangement capteur (200) selon la revendication 5 ou 6, comprenant en outre une troisième boucle électrique (L3) configurée de telle sorte qu'un flux de courant, qui est généré dans les deuxième et troisième boucles électriques (L₂) par un champ magnétique (B) et traverse à la fois la première (L₁), la deuxième (L₂) et la troisième boucle électrique (L₃), s'oppose à une perturbation exercée par le champ magnétique (B) sur le signal de sortie du capteur.

8. Arrangement capteur (200, 200') selon l'une des revendications 1 à 7, la première boucle électrique (L₁), au moins dans la mesure où elle est réalisée sur le support de circuit (220), est configurée de manière à inclure une surface la plus petite possible.

9. Arrangement capteur (200, 200') selon l'une des revendications précédentes, les deux portions de conducteur (230, 231) servant à alimenter le capteur (210).

10. Arrangement capteur selon l'une des revendications précédentes, avec lequel, parmi les deux portions de conducteur, l'une sert à l'alimentation électrique du capteur (210) et l'autre à détecter le signal de sortie généré par le capteur (210).

11. Arrangement capteur (200, 200') selon l'une des revendications précédentes, comprenant en outre un concentrateur de flux (240), notamment en un matériau ferromagnétique, pourvu d'un interstice (241), le capteur (210) étant disposé dans l'interstice (241).

12. Arrangement capteur (200, 200') selon l'une des revendications précédentes, le capteur (210) étant réalisé sous la forme d'un capteur de champ magnétique, notamment d'un capteur à effet Hall.

13. Convertisseur statique (140) pour une machine électrique (100), comprenant au moins un arrangement capteur (200, 200') selon l'une des revendications précédentes, qui est conçu pour détecter un courant de phase.

14. Utilisation d'un arrangement capteur (200, 200') selon l'une des revendications 1 à 12 pour détecter un courant de phase lors du fonctionnement d'une machine électrique (100) au moyen d'un convertisseur statique (140).
